Europäisches Patentamt

European Patent Office

Office européen des brevets

(11) Publication number: **0 323 432**
**A1**

## EUROPEAN PATENT APPLICATION

(21) Application number: **88870199.2**

(51) Int. Cl.⁴: **H 01 L 21/322**

(22) Date of filing: **29.12.88**

(30) Priority: **30.12.87 US 139533**

(43) Date of publication of application:
**05.07.89 Bulletin 89/27**

(84) Designated Contracting States:
**CH DE FR GB LI NL**

(71) Applicant: **MONSANTO COMPANY**
**800 North Lindbergh Boulevard**
**St. Louis, MO 63167 (US)**

(72) Inventor: **Golden, Paul Francis**
**1111 Bruckner Circle**
**Mountain View California 94040 (US)**

(74) Representative: **McLean, Peter et al**
**Monsanto Europe S.A. Patent Department Avenue de**
**Tervuren 270-272 Letter Box No 1**
**B-1150 Brussels (BE)**

(54) GaAs polycristalline gettering.

(57) Single crystal gallium arsenide material has recently received acceptance as a semiconductor substrate in the manufacture of electronic devices, such as integrated circuits. This invention describes single crystal gallium arsenide substrates having a 0.4 to 20.0 microns thick layer of polycrystalline gallium arsenide on the backside of the substrate from the device formation region. The substrate of this invention provides improved gettering capabilities of defects, contaminants and impurities away from the active device formation region of the substrate.

EP 0 323 432 A1

## Description

## GaAs POLYCRYSTALLINE GETTERING

### BACKGROUND OF THE INVENTION

#### FIELD OF THE INVENTION

This invention relates to the manufacture of electronic devices such as integrated circuits. Particularly, this invention relates to improved single crystal gallium arsenide (GaAs) material as a semiconductor substrate useful in the manufacture of integrated circuit devices. Specifically, this invention is directed to single crystal GaAs material as a semiconductor substrate having enhanced ability for gettering deleterious impurities, contaminants and defects during electronic device manufacture away from the region of device formation.

In the manufacture of integrated circuit devices on semiconductor substrates, single crystal GaAs material has recently found utility as a suitable semiconductor substrate. It has been known for some time, particularly with respect to silicon substrates, in the manufacture of integrated circuit devices that the presence of and introduction of defects, contaminants and impurities on and near the device formation region of the substrate creates excessive current leakages which greatly affects the yield of usable devices obtained. The art has recognized that the deleterious defects, contaminants and impurities can be to some extent relocated to non-harmful regions in the substrate material away from the device formation region. The methods and processes for diffusing and trapping the defects, contaminants and impurities away from the active device region both prior to and during device formation are termed gettering in the electronics industry and art.

#### DESCRIPTION OF THE PRIOR ART

Several techniques and processes for gettering in semiconductor materials, particularly silicon, to improve device yields have been disclosed in the art. However, for GaAs material there has been very little effort directed to gettering. Generally, gettering efforts for GaAs substrates has heretofore been concentrated on backside damage.

U. S. Patent No. 4,608,095 and U. S. Patent No. 4,053,335 are directed to gettering in silicon semiconductor substrates using a polysilicon layer on the backside of the silicon substrate. These patent contain considerable background on gettering, particularly with respect to silicon semiconductor substrates.

With any gettering means for semiconductor substrates useful in the electronic device manufacturing industry, the region of the substrate material where the devices are actually formed must be free to gettering sites to prevent adverse effects on the devices formed. Thus, a zone about 5-25 microns and preferably about 10-15 microns in depth from the surface of the substrate where the devices will be formed which is denuded of gettering sites must be present or created in the substrate to prevent device yield loss from defect interference.

With the present interest in GaAs as a substrate in electronic device manufacture and particularly with respect to the present complex and lengthy processing steps and increased circuit density and total circuit size on a wafer, it has become apparent improvements are needed in the gettering capabilities of GaAs substrates to cope with the increased requirements and provide effective gettering throughout the device processing steps in order to achieve an acceptable yield of good devices per wafer.

### SUMMARY OF THE INVENTION

Typical objects of this invention are to provide:
  1. a single crystal GaAs semiconductor substrate having improved gettering capabilities,
  2. a single crystal GaAs semiconductor substrate exhibiting enhanced gettering capabilities throughout device processing cycles, and
  3. a single crystal GaAs semiconductor substrate which exhibits reduced defect formation in the active device region and provided increased minority carrier lifetime.

Other objects, characteristics and advantages of this invention will become apparent to those skilled in the art from this disclosure and appended claims.

In accordance with this invention, an improved single crystal GaAs semiconductor substrate, such as in the form of a wafer, is provided which exhibits enhanced gettering capabilities throughout device manufacturing cycles, imparts improved minority carrier lifetime and reduces yield loss of devices made due to deleterious defect, contaminants and impurities. The enhanced gettering capabilities are imparted to the semiconductor wafer through external means, i.e., applying a layer of polycrystalline GaAs to the backside of the wafer.

The invention is based on improved gettering capability provided by the backside layer of polycrystalline GaAs on the single crystal GaAs wafer.

The polycrystalline GaAs layer on the single crystal GaAs wafer creates a strain resulting in a degree of bow or warpage in the wafer. The level of strain introduced is in part dependent upon the temperature at which the polycrystalline GaAs layer is applied. Suitable polycrystalline GaAs layers for the purpose of this invention can be deposited onto the wafers at temperatures below 600°C.

The thickness of the polycrystalline GaAs layer applied to the single crystal GaAs substrate can vary generally from 0.4 to 20.0 microns.

## DESCRIPTION OF PREFERRED EMBODIMENTS

This example illustrates the formation and deposition of a polycrystalline GaAs layer on a GaAs wafer useful as a substrate for electronic device manufacture.

A polished seed crystal of undoped GaAs is placed in a fused silica reaction tube located in a furnace. The GaAs seed crystal is placed on a graphite support inside said tube. The reaction tube is heated to below 600°C and a stream of hydrogen is directed through the tube for 15 minutes to remove oxygen from the surface of the GaAs seed crystal.

A stream of hydrogen is then directed through a reservoir of $GaCl_3$ maintained at about 130°C thus vaporizing the $GaCl_3$ which is then carried by the hydrogen through a heated tube from the reservoir to the reaction tube containing the GaAs seed crystal. Simultaneously, an equal stream of hydrogen is conducted through a tube containing a body of elemental arsenic heated to 540°C. The arsenic is carried by the hydrogen on through the tube to the reaction tube.

The mole fractions of $GaCl_3$, As and hydrogen are 0.05, 0.15 and 0.80, respectively. The separate streams of vaporized arsenic and $GaCl_3$ conjoin in the fused silica reaction tube where a reaction occurs between the hydrogen, arsenic and gallium in which a polycrystalline GaAs layer is formed on the seed crystal of GaAs. The polycrystalline GaAs layer thickness depends on temperature, GaAs seed crystal and time in the reaction tube.

The above example is based on a standard undoped single crystal GaAs wafer. However, the polycrystalline GaAs layer of this invention can be applied equally as effective to doped GaAs wafers.

Although the foregoing description has emphasized gettering improvement in device manufacturing processes, it will be equally as effective to prove an improved GaAs substrate free of surface defects, contaminants and impurities useful in the epitaxial deposition of coatings, such as single crystal GaAs, on to GaAs single crystal substrates. It is therefore to be understood that changes and modifications in form and detail of the invention and specific utilization thereof may be made without departing from the scope of the appended claims.

## Claims

1. A gallium arsenide semiconductor substrate designed for use in electronic device manufacturing processes with capability for gettering defects, contaminants and impurities deleterious to the device to a region away from the active device region of the substrate, comprising said single crystal gallium arsenide semiconductor material having a polycrystalline gallium arsenide layer with thickness of from 0.4 to 20.0 microns on the backside of the substrate from the devise formation region.

2. A substrate of Claim 1 wherein said polycrystalline gallium arsenide layers is applied by said GaAs semiconductor substrate by chemical vapor deposition of gallium and arsenide.

3. A gallium arsenide semiconductor substrate of either Claim 1 or Claim 2, comprising a single crystal gallium arsenide wafer having one mirror-like surface and the layer of polycrystalline gallium arsenide covering the other surface.

4. A process for manufacturing electronic devices wherein the devices are formed using thermal processing conditions and a semiconductor substrate comprising a single crystal gallium arsenide wafer having a backside layer from 0.4 to 20.0 microns thick of polycrystalline gallium arsenide.

## DOCUMENTS CONSIDERED TO BE RELEVANT

| Category | Citation of document with indication, where appropriate, of relevant passages | Relevant to claim | CLASSIFICATION OF THE APPLICATION (Int. Cl.4) |
|---|---|---|---|
| X | FR-A-2 026 656 (SIEMENS AG) * Page 1, line 1 - page 2, line 12; page 2, lines 29-35 * | 1,2,4 | H 01 L 21/322 |
| Y | | 3 | |
| Y | IEEE TRANSACTIONS ON ELECTRON DEVICES, vol. ED-32, no. 12, December 1985, pages 2839-2843, IEEE, New York, US; F.-C. WANG et al.: "The effects of substrate gettering on GaAs MESFET performance" * Page 2840, left-hand column * | 3 | |
| A | APPLIED PHYSICS LETTERS, vol. 35, no. 3, August 1979, pages 277-279, American Institute of Physics; T.J. MAGEE et al.: "Back surface gettering and Cr out-diffusion in VPE GaAs layers" * Page 278, left-hand column * | 1,3 | |
| A | ELECTRONICS LETTERS, vol. 5, no. 22, 30th October 1969, pages 553-554; P.R. DASTIDAR et al.: "Gettering of impurities from gallium arsenide" * Whole document * | 1,3,4 | **TECHNICAL FIELDS SEARCHED (Int. Cl.4)** H 01 L |

The present search report has been drawn up for all claims

| Place of search | Date of completion of the search | Examiner |
|---|---|---|
| THE HAGUE | 23-03-1989 | GELEBART J.F.M. |